Europäisches Patentamt

European Patent Office

Office européen des brevets

(11) Veröffentlichungsnummer: **0 347 443 B1**

# (12) EUROPÄISCHE PATENTSCHRIFT

(45) Veröffentlichungstag der Patentschrift :
**12.08.92 Patentblatt 92/33**

(21) Anmeldenummer: **88909972.7**

(22) Anmeldetag : **07.11.88**

(86) Internationale Anmeldenummer :
**PCT/DE88/00689**

(87) Internationale Veröffentlichungsnummer :
**WO 89/05520 15.06.89 Gazette 89/13**

(51) Int. Cl.$^5$: **H01L 31/02, H01L 31/052**

(54) **SOLARMODUL.**

(30) Priorität : **08.12.87 DE 3741485**

(43) Veröffentlichungstag der Anmeldung :
**27.12.89 Patentblatt 89/52**

(45) Bekanntmachung des Hinweises auf die
Patenterteilung :
**12.08.92 Patentblatt 92/33**

(84) Benannte Vertragsstaaten :
**AT BE CH DE FR GB IT LI NL SE**

(56) Entgegenhaltungen :
**EP-A- 0 179 556**
**FR-A- 2 342 558**

(56) Entgegenhaltungen :
**Seventh E.C. Photovoltaic Solar Energy Conference, Proceedings of the International Conference, Sevilla, Spain, 27-31 October1986, D. Reidel Publishing co., (Dordrecht, NL), M. Collares-Pereira et al.: "A novel combination of low concentration CPCcollectors with bifacial photovoltaic cells", pages 1226-1228, see the whole document (cited in the application)**
**The Conference Record of the Fifteenth IEEE Photovoltaic Specialists Conference - 1981, Kissimmee, Florida, 12-15 May 1981,IEEE, (US), B.D. Shafer et al.: "Development and evaluation of a low cost photovoltaic concentrator module", pages 317-322, seepages 317-318; figures 10-11**

(73) Patentinhaber :
**FRAUNHOFER-GESELLSCHAFT ZUR FÖRDERUNG DER ANGEWANDTEN FORSCHUNG E.V.**
**Leonrodstrasse 54**
**W-8000 München 19 (DE)**

(72) Erfinder : **GOETZBERGER, Adolf**
**Friedhofstrasse 13**
**W-7802 Merzhausen (DE)**

(74) Vertreter : **Rackette, Karl, Dipl.-Phys. Dr.-Ing**
**Kaiser-Joseph-Strasse 179 Postfach 1310**
**W-7800 Freiburg (DE)**

## Beschreibung

Die Erfindung betrifft ein Solarmodul mit mehreren zweiseitig wirksamen Solarzellen, die über einer Anordnung aus mehreren parallel zueinander verlaufenden rinnenförmigen und im Querschnitt halbkreisförmigen Spiegeln angeordnet sind, die den neben den Solarzellen einfallenden Teil der Solarstrahlung auf die Unterseite der Solarzellen umlenken, wobei die Solarzellen rechteckförmig ausgestaltet sind und quer zur Längsrichtung der rinnenförmigen Spiegel jeweils zur Hälfte über die Spiegelöffnung ragen.

Eine solches Solarmodul ist aus der FR-A-2 342 558 bekannt und gestattet einen einfachen mechanischen Aufbau bei gleichzeitig hohem Wirkungsgrad des Moduls, da durch die rinnenförmigen Spiegel zurückgeworfenes Licht auf der Rückseite der zweiseitigen Solarzellen aufgenommen werden kann.

Ausgehend von diesem Stand der Technik liegt der Erfindung die Aufgabe zugrunde ein Solarmodul der eingangs genannten Art so zu verbessern, daß ohne einen komplizierteren mechanischen Aufbau des Solarmoduls der erreichbare Wirkungsgrad erhöht wird.

Diese Aufgabe wird erfindungsgemäß dadurch gelöst, daß die Solarzellen eine dem Durchmesser der rinnenförmigen Spiegel im wesentlichen entsprechende Breite aufweisen, daß die Solarzellen jeweils Konzentratoranordnungen sind, die zweiseitig wirksame Solarelemente enthalten, die jeweils mit einem oberen Konzentrator und einem unteren Konzentrator gekoppelt sind, und daß die Konzentratoranordnungen bezüglich der Anordnung der Solarelemente jeweils zwei spiegelbildlich zueinander angeordnete Konzentratoren aufweisen, die über mehrere im Schnitt seitlich parabelförmig begrenzte trogförmige Leisten verfügen.

Dadurch, daß Konzentratoren mit den Solarelementen verwendet werden, kann in einfacher Weise der Wirkungsgrad des Solarmoduls verbessert werden. Dadurch, daß die zweiseitig angeordneten Konzentratoranordnungen über mehrere im Schnitt seitlich parabelförmig begrenzte trogförmige leisten verfügen, wird selbst unter ungünstigem Winkel einfallendes Licht sicher zu einem der Solarelemente geleitet.

Zweckmäßige Ausgestaltungen und Weiterbildungen der Erfindung sind in den Unteransprüchen gekennzeichnet.

Nachfolgend werden Ausführungsbeispiele der Erfindung anhand der Zeichnung näher erläutert. Es zeigen:

Fig. 1 einen Ausschnitt eines Solarmoduls in einer perspektivischen Ansicht,

Fig. 2 einen Querschnitt durch die einer Solarzelle zugeordneten Spiegel,

Fig. 3 die Unterseite einer Solarzelle mit dem Ableitgitter und einer mittig angeordneten Stromsammelschiene,

Fig. 4 eine Konzentratoranordnung mit mehreren Solarelementen und

Fig. 5 ein Solarmodul gemäß der Erfindung mit mehreren Solarzellen, die jeweils aus mehreren Solarelementen und zwei Konzentratoren aufgebaut sind.

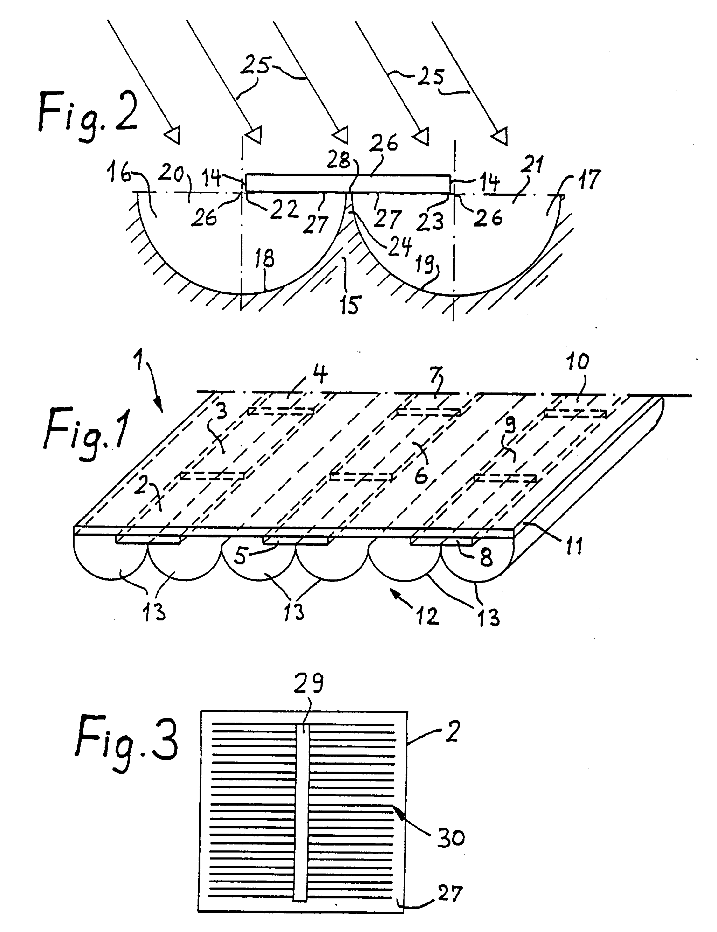

In Fig. 1 erkennt man in perspektivischer Ansicht ein Solarmodul 1 mit einer Vielzahl von doppelseitig wirksamen Solarzellen 2 bis 10, die zwischen einer transparenten, Licht nicht streuenden Glasscheibe 11 und einer Reflektorstruktur 12 angeordnet sind.

Die Reflektorstruktur 12 besteht aus einer Vielzahl von rinnenförmigen Spiegeln 13, die parallel zueinander verlaufend, dicht nebeneinanderliegend angeordnet sind. Die ebenen Endflächen der Reflektorstruktur 12 an den Stirnseiten der rinnenförmigen Spiegel 13 sind vorzugsweise reflektierend ausgebildet, um Lichtverluste möglichst weitgehend zu meiden. Auch die nicht aktiven schmalen Randflächen 14 der in Fig. 1 vergrößert dargestellten Solarzellen 2 bis 10 können zur Reduzierung von Strahlungsverlusten verspiegelt sein.

Die rinnenförmigen Spiegel 13 können auf verschiedene Arten und Weisen hergestellt sein. Bei dem in Fig. 2 vergrößert dargestellten Ausschnitt aus einem ersten Ausführungsbeispiel für die Reflektorstruktur 12 erkennt man einen Reflektorkörper 15, der parallel zueinander verlaufende rinnenförmige Ausnehmungen 16 und 17 aufweist, die der Solarzelle 2 zugeordnete Spiegelflächen 18 und 19 aufweisen. Die Ausnehmungen 16, 17 sowie die Spiegelflächen 18, 19 sind im Schnitt rechtwinklig zur Längsachse der rinnenförmigen Spiegel 13 halbkreisförmig. Die Spiegelflächen 18, 19 können z.B. durch Beschichten des Reflektorkörpers 15 mit einem das Sonnenlicht gut reflektierenden Material hergestellt werden.

Wie man in Fig. 2 deutlich erkennt, ragt die Solarzelle 2 seitlich über die im Schnitt halbkreisförmigen Ausnehmungen 16, 17 bis etwa zur Mitte der in Fig. 2 nach oben weisenden Öffnungen 20, 21 hinein. Auf diese Weise liegen die Unterkanten 22, 23 der Solarzelle 2 gegenüber einer Geraden geringfügig zurückversetzt, die durch die Mittelpunkte der Kreise verläuft, die die halbkreisförmige Form der rinnenförmigen Spiegel 13 beschreiben.

Wenn die Breite der Solarzelle 2 genau dem Durchmesser der halbkreisförmigen Ausnehmungen 16, 17 entspricht, liegen die Unterkanten 22, 23 jeweils in einem Abstand der halben Stegbreite des Steges 24 zwischen den Ausnehmungen 16, 17 gegenüber den Mittelpunkten 26 in Richtung auf den Steg 24 versetzt.

In Fig. 2 erkennt man die durch Pfeile 25 veranschaulichte Strahlung, die zum Teil die Oberseite 26 der, wie in Fig. 1 erkennbar, rechteckförmigen Solarzelle 2 beaufschlagt. Ein weiterer Teil, der durch die Pfeile 25 veranschaulichten Strahlung dringt in die verspiegelten Ausnehmungen 16, 17 ein und wird zur Unterseite 27 der Solarzelle 2 umgelenkt. Die Unterseite 27 erstreckt sich dabei etwa mit der einen Hälfte über die verspiegelte, im Schnitt halbkreisförmige Ausnehmung 16 und mit etwa der anderen Hälfte über die verspiegelte, im Schnitt halbkreisförmige Ausnehmung 17.

Im Bereich der Auflage der Solarzelle 2 auf dem Steg 24 befindet sich ein von der Strahlung nicht erreichbarer passiver Streifen 28, der einerseits zur Abstützung der Solarzelle 2 und andererseits zum Verlegen einer Stromsammelschiene 29 (Busbar) dient, die in Fig. 3 zusammen mit dem Ableitgitter 30 der Solarzelle 2 in einer Aufsicht auf die Solarzelle 2 von unten dargestellt ist.

Die in Fig. 2 ausschnittsweise dargestellte Struktur kann statt durch einen mehr oder weniger massiven Reflektorkörper 15 auch durch entsprechend aus Blech geformte einzelne rinnenförmige Spiegel 13, die mit ihren Rändern verbunden werden, oder durch ein einstückiges entsprechend den zahlreichen rinnenförmigen Spiegeln 13 gebogenes Blech hergestellt werden. Das zur Erstellung der rinnenförmigen Spiegel 13 verwendete Blech wird dabei auf der konkaven Seite verspiegelt, um eine Umlenkung der in die rinnenförmige Spiegel 13 einfallenden Strahlung auf die Unterseiten 27 der Solarzellen 2 bis 10 zu bewirken. Der Innendurchmesser der aus Blech hergestellten rinnenförmigen Spiegel 13 entspricht wieder der Solarzellenbreite, das heißt dem Abstand zwischen den beiden in Fig. 2 dargestellten Randflächen 14.

Eine weitere Realisierungsmöglichkeit der Reflektorstruktur mit rinnenförmigen Spiegeln 13 besteht darin, Halbrundstäbe oder Tröge oder massivem Glas oder Kunststoff auf der konvexen Außenseite sowie den ebenen Stirnseiten zu verspiegeln und jeweils entlang den Radialebenen optisch an die Deckflächen der Solarzellen 2 bis 10 sowie die Abdeckung 11 anzukoppeln. Dadurch werden Reflexionsverluste an der Innenseite der Deckfläche vermieden sowie eine bessere Kühlung der Solarzellen bewirkt. Die Ankopplung der Halbrundstäbe an die Solarzellen 2 bis 10 sowie die Abdeckung 11 kann in der Weise geschehen, daß jeweils zwei benachbart angeordnete massive Glas- oder Kunststoffhalbrundstäbe mit einer Ausnehmung versehen werden, die sich axial erstreckt und eine Tiefe hat, die der Bauhöhe der Solarzellen 2 bis 10 entspricht. Seitlich ragen die Ausnehmungen jeweils von der rechten bzw. linken Berandung bis etwa kurz vor die durch die Mittelpunkte 26 verlaufenden Geraden. Da die aus massivem außen verspiegelten Material hergestellten rinnenförmigen Spiegel 13 jeweils einen halbkreisförmigen Schnitt haben, ergibt sich eine günstige Materialausnutzung wenn Rundstäbe entlang ihrer Mittelebene geteilt werden.

Statt in den Halbrundstäben Ausnehmungen für die Solarzellen 2 bis 10 vorzusehen, ist es auch möglich, die Halbrundstäbe neben den Auflageflächen der Solarzellen 2 bis 10 durch einen im Querschnitt rechteckförmigen Absatz zu erhöhen, dessen Höhe der Bauhöhe der Solarzellen 2 bis 10 entspricht, und der mit der Abdeckung 11 optisch gut gekoppelt ist. Auf den von den Randflächen 14 der Solarzellen 2 bis 10 wegweisenden Seiten sind die im Querschnitt rechteckförmigen Absätze ebenso wie die runde Außenseite der Halbrundstäbe verspiegelt.

Schließlich ist es auch möglich, den Innenraum der rinnenförmigen Spiegel 13 statt mit einem festen Material mit einem für Kühlzwecke aktiv oder passiv zirkulierenden brechenden Medium zu füllen. Durch den Transport des Mediums aufgrund einer Wärmeströmung oder mit Hilfe einer Pumpe läßt sich eine gute Kühlung der Solarzellen 2 bis 10 verwirklichen.

Wenn die rinnenförmigen Spiegel 13 aus massiven, in Längsrichtung halbierten Glas- oder Kunststoffrundstäben ohne Vertiefung zur Aufnahme der Solarzellen auf der der Glasscheibe 11 zugewandten Seite hergestellt sind, entstehen zwischen der Glasscheibe 11 und den ebenen Oberseiten der Halbrundstäbe Kanäle, deren Höhe der Bauhöhe der Solarzellen 2 bis 10 und deren Breite dem seitlichen Abstand der Solarzellen 2 bis 10 bzw. dem Durchmesser der Halbrundstäbe entspricht. Diese Kanäle können ebenfalls für Kühlzwecke verwendet werden, indem Gase oder Flüssigkeiten veranlaßt werden, diese Kanäle zu durchströmen.

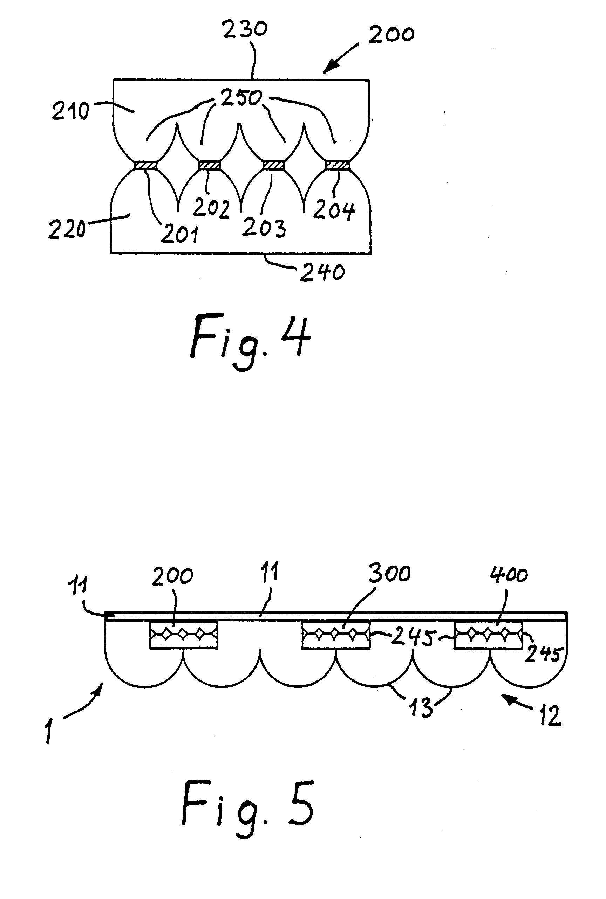

Fig. 4 zeigt im Schnitt mehrere Solarelemente 201, 202, 203 und 204 einer zweiseitg wirksamen Konzentratoranordnung 200, die aus einem oberen Konzentrator 210 und einem unteren Konzentrator 220 zusammengesetzt ist. Die Solarelemente 201 bis 204 sind wie das Solarelement 2 und die übrigen Solarelemente 3 bis 10 sowohl auf der Oberseite als auch auf der Unterseite lichtempfindlich.

Der obere Konzentrator 210 hat beispielsweise die in Fig. 4 erkennbare Form, die es gestattet, auf die Oberseite 230 einfallendes Licht zu konzentrieren und zu den Oberseiten der Solarelemente 201 bis 204 zu führen. Entsprechend wird das die Unterseite 240 beaufschlagende Solarlicht auf die Unterseiten der Solarelemente 201 bis 204 konzentriert. Der obere Konzentrator 210 und der untere Konzentrator 220 der Konzentratoranordnung 200 sind jeweils identisch aufgebaut.

In Fig. 5 ist dargestellt, wie gemäß der Erfindung mehrere Konzentratoranordnungen 200, 300 und 400 mit jeweils einer Vielzahl von Solarelementen 201 bis 204 an Stelle der in Fig. 1 erkennbaren Solarzellen 2, 5 und 8 verwendet werden.

Wenn man kleine Solarelemente 201 bis 204 verwendet, werden die Konzentratoranordnungen 200, 300,

EP 0 347 443 B1

400 sehr dünn, so daß die optischen Verhältnisse denjenigen in den Figuren 1 und 2 entsprechen. Bei dickeren Konzentratoranordnungen 200, 300, 400, wie in Fig. 5, sind die Seitenflächen 245 mit Spiegeln versehen, um die Lichtverluste möglichst klein zu halten.

Unter Bezug auf Fig. 1 wird darauf hingewiesen, daß bei dem in Fig. 1 dargestellten Ausführungsbeispiel jeweils mehrere Solarzellen 2, 3, 4 bzw. 5, 6, 7 oder 8, 9, 10 in einer Reihe angeordnet sind. Eine weitere Möglichkeit der Anordnung der Solarzellen 2 bis 10 besteht darin, die Solarzellen 3, 6 und 9 jeweils um eine Solarzellenbreite seitlich versetzt gegenüber den Solarzellen 2, 4 bzw. 5, 7 und 8, 10 anzuordnen, so daß die Solarzellen 2 bis 10 nicht in Streifen, sondern ähnlich einem Schachbrett angeordnet sind.

## Patentansprüche

1. Solarmodul mit mehreren zweiseitig wirksamen Solarzellen (200, 300, 400), die über einer Anordnung aus mehreren parallel zueinander verlaufenden rinnenförmigen und im Querschnitt halbkreisförmigen Spiegeln (12, 13) angeordnet sind, die den neben den Solarzellen (200, 300, 400) einfallenden Teil der Solarstrahlung auf die Unterseite der Solarzellen (200, 300, 400) umlenken, wobei die Solarzellen (200, 300, 400) rechteckförmig ausgestaltet sind und quer zur Längsrichtung der rinnenförmigen Spiegel (13) jeweils zur Hälfte über die Spiegelöffnung (20, 31) ragen, **dadurch gekennzeichnet**, daß die Solarzellen (200, 300, 400) eine dem Durchmesser der rinnenförmigen Spiegel (13) im wesentlichen entsprechende Breite aufweisen, daß die Solarzellen jeweils Konzentratoranordnungen (200, 300, 400) sind, die zweiseitig wirksame Solarelemente (201 bis 204) enthalten, die jeweils mit einem oberen Konzentrator (210) und einem unteren Konzentrator (220) gekoppelt sind, und daß die Konzentratoranordnungen (200, 300, 400) bezüglich der Anordnung der Solarelemente (201 bis 204) jeweils zwei spiegelbildlich zueinander angeordnete Konzentratoren (210, 220) aufweisen, die über mehrere im Schnitt seitlich parabelförmig begrenzte trogförmige Leisten (250) verfügen.

2. Solarmodul nach Anspruch 1, dadurch gekennzeichnet, daß die Konzentratoranordnungen (200, 300, 400) auf der Unterseite einer transparenten Licht nicht streuenden Abdeckplatte (11) angeordnet sind, die das gesamte Solarmodul (1) auf dessen Oberseite überdeckt.

3. Solarmodul nach Anspruch 1 oder Anspruch 2, dadurch gekennzeichnet, daß die Konzentratoranordnungen (200, 300, 400) schachbrettartig angeordnet sind.

4. Solarmodul nach Anspruch 1 oder Anspruch 2, dadurch gekennzeichnet, daß die Konzentratoranordnungen (200, 300, 400) sich einander berührend entlang von Zeilen angeordnet sind, wobei zwischen den Solarzellenzeilen zeilenförmige Einstrahlungsflächen freibleiben.

5. Solarmodul nach einem der vorstehenden Ansprüchen, dadurch gekennzeichnet, daß die rinnenförmigen Spiegel (13) auf der Innenseite eines Blechs oder eines Reflektorkörpers ausgebildet sind und Strömungskanäle für ein transparentes Licht brechendes Kühlmedium begrenzen.

6. Solarmodul nach einem der Ansprüche 1 bis 4, dadurch gekennzeichnet, daß die rinnenförmigen Spiegel (13) massive Glas- oder Kunststoffhalbrundstäbe sind, die auf ihren konvexen Außenseiten verspiegelt sind.

7. Solarmodul nach Anspruch 4 und Anspruch 6, dadurch gekennzeichnet, daß die Glas- oder Kunststoffhalbrundstäbe auf der zur Abdeckung (11) weisenden Seite eine sich etwa über die Hälfte des Stabdurchmessers erstreckende Ausnehmung zur Aufnahme der Konzentratoranordnungen (200, 300, 400) aufweisen, deren Tiefe der Bauhöhe der Konzentratoranordnungen (200, 300, 400) entspricht.

8. Solarmodul nach Anspruch 4 und Anspruch 6, dadurch gekennzeichnet, daß die Glas- oder Kunststoffhalbrundstäbe neben den Auflageflächen der Konzentratoranordnungen (200, 300, 400) einen im Querschnitt rechteckförmigen Absatz aufweisen, der mit der Abdeckung (11) optisch gut gekoppelt ist.

## Claims

1. A solar module comprising a plurality of solar cells (200, 300, 400) which are effective on two sides and which are arranged over an arrangement comprising a plurality of channel-shaped mirrors (12, 13) which extend in mutually parallel relationship and which are of semicircular cross-section and which deflect the part of the solar radiation which is incident beside the solar cells (200, 300, 400) on to the underside of the solar cells (200, 300, 400), wherein the solar cells (200, 300, 400) are of a rectangular configuration and each project transversely to the longitudinal direction of the channel-shaped mirrors (13) halfway over the mirror opening (20, 31), **characterised in that** the solar cells (200, 300, 400) are of a width which substantially corresponds to the diameter of the channel-shaped mirrors (13), that the solar cells are respectively concentrator arrangements (200, 300, 400) which contain solar elements (201 to 204) which are effective on two sides and which are respectively coupled to an upper concentrator (210) and a lower concentrator (220), and that the concentrator arrangements (200, 300, 400), with respect to the arrangement of the solar elements (201 to 204), each have two concentrators (210, 220) which are arranged in mirror image relationship with each other and which have a plurality of trough-shaped bars (250) which are of a laterally parabolically delimited configuration in section.

2. A solar module according to claim 1 characterised in that the concentrator arrangements (200, 300, 400) are disposed on the underside of a transparent cover plate (11) which does not disperse light and which covers the entire solar module (1) on the top side thereof.

3. A solar module according to claim 1 or claim 2 characterised in that the concentrator arrangements (200, 300, 400) are arranged in a chessboard-like configuration.

4. A solar module according to claim 1 or claim 2 characterised in that the concentrator arrangements (200, 300, 400) are arranged in contact with each other along lines, wherein line-form irradiation surfaces remain free between the lines of solar cells.

5. A solar module according to one of the preceding claims characterised in that the channel-shaped mirrors (13) are provided on the inside of a metal sheet or a reflector body and define flow ducts for a transparent light-refracting cooling agent.

6. A solar module according to one of claims 1 to 4 characterised in that the channel-shaped mirrors (13) are solid glass or plastics half-round bars which are mirrored on their convex outsides.

7. A solar module according to claim 4 and claim 6 characterised in that the glass or plastics half-round bars are provided on the side which faces towards the cover (11) with an opening extending approximately over half the bar diameter, to accommodate the concentrator arrangements (200, 300, 400), the depth thereof corresponding to the structural height of the concentrator arrangements (200, 300, 400).

8. A solar module according to claim 4 and claim 6 characterised in that, beside the support surfaces for the concentrator arrangements (200, 300, 400) the glass or plastics half-round bars have a step which is of rectangular cross-section and which is optically well coupled to the cover (11).

## Revendications

1. Module solaire doté de plusieurs cellules solaires à double face (200, 300, 400), agencées sur un dispositif composé de plusieurs miroirs (12, 13) en forme de rigole, de section semi-circulaire et parallèles entre eux, qui dévient la partie des rayons solaires arrivant à côté des cellules solaires (200, 300, 400) sur la face inférieure des cellules solaires (200, 300, 400), les cellules solaires (200, 300, 400) étant de forme rectangulaire et dépassant de moitié au-dessus de l'ouverture des miroirs (20, 31), perpendiculairement à l'axe longitudinal des miroirs (13) en forme de rigole, **caractérisé en ce que** les cellules solaires (200, 300, 400) présentent une largeur correspondant essentiellement au diamètre du miroir (13) en forme de rigole, en ce que les cellules solaires sont respectivement des dispositifs concentrateurs (200, 300, 400), qui contiennent des éléments solaires à double face (201 à 204), couplés respectivement avec un concentrateur supérieur (210) et un concentrateur inférieur (220) et en ce que les dispositifs concentrateurs (200, 300, 400) présentent respectivement deux concentrateurs agencés symétriquement par rapport au dispositif d'éléments solaires (201 à 204), qui sont pourvus de plusieurs baguettes en forme d'auge, délimitées de façon parabolique en coupe latérale.

2. Module solaire selon la revendication 1, caractérisé en ce que les dispositifs concentrateurs (200, 300, 400) sont disposés sur la face inférieure d'une plaque de recouvrement (11) transparente ne dispersant pas la lumière, qui recouvre toute la surface supérieure du module solaire (1).

3. Module solaire selon la revendication 1 ou 2, caractérisé en ce que les dispositifs concentrateurs (200, 300, 400) sont disposés en échiquier.

4. Module solaire selon la revendication 1 ou 2, caractérisé en ce que les dispositifs concentrateurs (200, 300, 400) sont disposés en contact les uns avec les autres, le long de lignes, des surfaces de rayonnement en forme de ligne demeurant libres entre les lignes de cellules solaires.

5. Module solaire selon l'une quelconque des revendications précédentes, caractérisé en ce que les miroirs (13) en forme de rigole sont formés sur la face interne d'une tôle ou d'un corps réfléchissant et délimitent des canaux d'écoulement pour un agent de refroidissement transparent réfractant la lumière.

6. Module solaire selon l'une quelconque des revendications 1 à 4, caractérisé en ce que les miroirs en forme de rigole (13) sont des barres semi-circulaires en verre ou en matière plastique massifs, dont les faces externes convexes sont recouvertes d'une couche réfléchissante.

7. Module solaire selon les revendications 4 et 6, caractérisé en ce que les barres semi-circulaires en verre ou en matière plastique présentent sur leur côté orienté vers la plaque de recouvrement (11) un évidement ménagé sur environ la moitié du diamètre de la barre, pour recevoir les dispositifs concentrateurs (200, 300, 400), et dont la profondeur correspond à la hauteur de montage des dispositifs concentrateurs (200, 300, 400).

8. Module solaire selon les revendications 4 et 6, caractérisé en ce que les barres semi-circulaires en verre ou en matière plastique présentent, à côté des surfaces d'appui des dispositifs concentrateurs (200, 300, 400) un épaulement de section rectangulaire, présentant un bon couplage optique avec la plaque de recouvrement (11).

*Fig.2*

*Fig.1*

*Fig.3*

Fig. 4

Fig. 5